# EUROPÄISCHE PATENTSCHRIFT

(11) **EP 1 420 448 B1**
(45) Veröffentlichungstag und Bekanntmachung des Hinweises auf die Patenterteilung: **09.08.2006**
(21) Anmeldenummer: 03023382.9
(22) Anmeldetag: 16.10.2003
(51) Int. Cl.: H01L 23/544, H01L 23/528, H01L 23/522

(54) **Teststruktur zur Bestimmung der elektrischen Belastbarkeit von Kontakten**
Test structure to determine the electric stability of contacts
Structure de test pour déterminer la stabilité électrique des contacts

(30) Priorität: 15.11.2002 DE 10253626
(43) Veröffentlichungstag der Anmeldung: 19.05.2004
(73) Patentinhaber: Infineon Technologies AG, 81669 München (DE)
(72) Erfinder: Goller, Klaus, 01069 Dresden (DE); Wenzel, Roland, Dr., 80336 München (DE)
(74) Vertreter: Lippert, Stachow & Partner

(56) Entgegenhaltungen:
- US-A- 5 410 161
- US-A- 5 598 010
- US-A- 5 773 857
- US-A1- 2001 040 301
- US-A1- 2002 024 148

## Beschreibung

Die Erfindung betrifft eine Teststruktur zur Bestimmung der elektrischen Belastbarkeit von Kontakten, insbesondere von elektrischen Verbindungen zwischen übereinander angeordneten Leitbahnen durch in Kontaktlöchern angeordnete Vias auf einem Testchip.

Es ist bekannt, dass es bei der Herstellung von hochintegrierten Schaltkreisen insbesondere bei der Realisierung der einzelnen Verdrahtungsebenen (z.B. Polysilizium-Layer oder Aluminium-Layer) Defekte und in der Folge Fehler auftreten können, welche die Funktion solcher Schaltkreise in Frage stellen können, oder zu einem Frühausfall führen.

Um hier eine einigermaßen zuverlässige Vorhersage treffen zu können, wurden beispielsweise Teststrukturen in Form geometrischer Gebilde entwickelt, mit deren Hilfe Defekte innerhalb einer großen Fläche zuverlässig detektiert werden können. Für die Kontaktierung zu Testzwecken werden die Bond-Pad-Konfigurationen üblicher Standard-Chips verwendet. Diese Teststrukturen werden auf Testchips in geringen Stückzahlen parallel mit der eigentlichen Produktion hergestellt und dann entsprechenden Testprozeduren unterzogen. Dabei hat es sich als günstig erwiesen, wenn die Testchips gleichzeitig mit den eigentlichen zu produzierenden Chips auf dem selben Wafer angeordnet werden und damit den selben Produktionsprozess durchlaufen.

Ein Beispiel für solche Teststrukturen sind sogenannte Karree-Teststrukturen in Form einer 3D- oder 2D-Matrix, so dass grundsätzlich auch Fehler in vertikalen Strukturen (Vias) detektiert werden können. Besonders wichtig ist hier bei der Produkt- oder Technologiequalifikation insbesondere das Testen der elektrischen Belastbarkeit der Vias zwischen den Metallebenen. Mit Hilfe von speziellen Beschleunigungsverfahren kann dann eine Aussage über die maximale Strom- oder Spannungsfestigkeit unter Angabe einer maximalen Lebenszeit und Betriebstemperatur getroffen werden.

Um dies zu erreichen, muss bei den sogenannten "downstream" oder "upstream Strukturen, also Vias mit entsprechender Stromrichtung, der jeweils kritische Übergang (Via auf Metallbahn) mit minimaler Überlappung realisiert werden. Dies ist in der Regel der Bereich des Landing Pads, also bei realen Chips die Kontaktfläche zwischen zwei Metallebenen, auf der ein oder mehrere Vias plaziert sind. Damit kann in einer Teststruktur der sogenannte "worst-case" simuliert werden, d.h. dass bei der Anordnung der Kontakte und des gewählten Überlapps in der Teststruktur zum Testen vom schlimmsten Fall ausgegangen wird.

Bei den bisher bekannt gewordenen Teststrukturen ist es allerdings nicht möglich, die Fälle sehr hoher bis maximaler Belegungsdichte zu simulieren. Das Problem besteht hier darin, dass während der Herstellung der obersten Leitbahn im Bereich des Landing-Pads eine prozessbedingte unkontrollierte Aufweitung erfolgen kann, die zu einem deutlichen Überstand führt. Diese Aufweitung entsteht bei der Belichtung und Entwicklung des Photolacks (Resist) und der anschließenden Strukturierung der Leitbahn und ist daher prozessbedingt. Mit solchen Teststrukturen kann nur ein Teil der erforderlichen Tests abgedeckt werden, die allerdings nicht zuverlässig und jederzeit den kritischen Fall simulieren können, sondern nur deutlich entspanntere Bedingungen als im Produktdesign abbilden.

In der US 5 598 010 wird eine Halbleiteranordnung mit einer Dummy-Struktur beschrieben, mit welcher der "Micro-Loading"-Effekt vermieden werden soll. Um das zu erreichen, wird ein MOS-Transistor zusammen mit einer Dummy-Struktur oder einer Vielzahl von Gate-Elektroden ausgestattet. Mit Hilfe von Teststrukturen soll festgestellt werden, ob ein Überätzen an den Gateelektroden insbesondere beim Trockenätzen stattfindet.

Verursacht wird das Überätzen durch den hohen Dampfdruck der Reaktionsprodukte, der gegen das Material drückt und verhindert, dass die Reaktionsprodukte die Oberfläche des Materiales schnell verlassen. Die Reaktionsprodukte verhindern, dass die Ätzsubstanzen auf das ungeätzte Material auftreffen, so dass ein Unterätzen stattfinden kann.

Mit einer solchen Anordnung ist es allerdings nicht möglich, die kritische Strombelastbarkeit von Durchkontaktierungen zwischen einzelnen Metallisierungsebenen zu bestimmen.

Die US 5 410 161 offenbart eine Testtransistor-Anordnung zur Prüfung des Kontaktwiderstandes, der Schwellenspannung usw. von Gate-Elektroden, wobei auf beiden Seiten neben der Gate-Elektrode Dummy-Gates angeordnet sind.

Aus der US 2002 024 148 A1 geht schließlich hervor, dass durch Lichtstreuung, Interferenzen usw. die zur Strukturierung verwendete Maske infolge von Dichteunterschieden hinterleuchtet wird. Das führt dann dazu, dass der Abstand der Verdrahtung zueinander verringert wird. Um das zu vermeiden, werden auf der Maske Dummy-Strukturen eingefügt.

Die Ermittlung der kritischen Strombelastbarkeit von Durchkontaktierungen ist mit solchen Strukturen nicht möglich.

Der Erfindung liegt nunmehr die Aufgabe zugrunde, eine Teststruktur zur Bestimmung der elektrischen Belastbarkeit von Übergängen zwischen Metallbahnen zu erzeugen, mit der auf einfache Weise eine hohe bis sehr hohe Belegungsdichte für den ungünstigsten Fall getestet werden kann.

Die der Erfindung zugrundeliegende Aufgabenstellung wird bei einer Teststruktur der eingangs genannten Art dadurch gelöst, dass um das Via bzw. Kontaktloch und die zugehörige Leitbahn herum, zumindest in der Metallisierungsebene der kritischen Kante mehrere Dummy-Leitbahnen mit maximaler Belegungsdichtedicht benachbart, eine "nested" Umgebung bildend angeordnet sind, indem indem die Verdrahtung im Schaltungslayout so dicht als möglich gesetzt wird.

Mit dieser besonders einfachen Lösung, der Erzeugung einer sogenannten "nested Umgebung", wird erreicht, dass die in normalen Strukturen von Schaltkreisen bei der Fotolithografie und der nachfolgenden Strukturierung der Leitbahnen mögliche Aufweitung bei den Teststrukturen sicher vermieden wird.
und ein Minimum an Überdeckung gesichert wird, wie im Schaltungslayout gemäß der Designregeln vorgegeben.

Eine Ausgestaltung der Erfindung ist dadurch gekennzeichnet, dass die Dummy-Leitbahnen das Via bzw. Kontaktloch und die zugehörige Leitbahn im wesentlichen äquidistant umgeben.

Weiterhin ist vorgesehen, dass die Leitbahnen und die Dummy-Leitbahnen aus Metall, Aluminium oder Polysilizium bestehen.

Die Erfindung soll nachfolgend an einem Ausführungsbeispiel näher erläutert werden. In den zugehörigen Zeichnungen zeigen:
- Fig.1:: einen schematischen Querschnitt von übereinander liegenden Leitbahnen (Metallisierungsebene 3 / Me3) und Metallisierungsebene 4 /Me4) und ein diese über ein Kontaktloch verbindendes Via als "Downstream Struktur";
- Fig. 2:: eine schematische Darstellung der Leitbahnen der Metallisierungsebene 3 (Me3) mit verfälschten Struktureigenschaften infolge der Aufweitung der Leitbahn dieser Metallisierungsebene;
- Fig. 3:: eine schematische Darstellung der Metallisierungs-ebene 3 mit erfindungsgemäß um die aktive Leitbahn herum angeordneten Dummy-Leitbahnen; und
- Fig. 4:: eine schematische Schnittdarstellung der Anordnung nach Fig. 3.

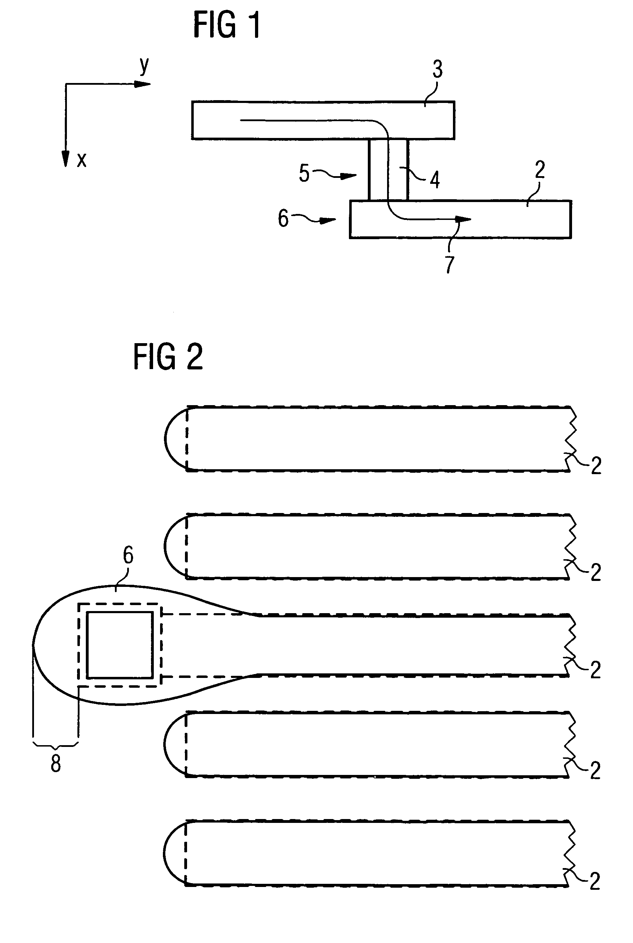

Fig. 1 zeigt eine schematische Darstellung einer Teststruktur 1 mit einer Leitbahn 2 der Metallisierungsebene 3 (Me3) sowie einer Leitbahn 3 der darüber liegenden Metallisierungsebene (Me4), die über ein Via 4 in einem Kontaktloch 5 zwischen beiden Leitbahnen 2, 3 miteinander elektrisch verbunden sind. Dabei ist als kritische Kante 6 der Übergang vom Via 4 zur Leitbahn 2 anzusehen (im Falle einer Downstream Struktur). Im Falle einer "Upstream Struktur" wäre die kritische Kante (nicht dargestellt) sinngemäß der Übergang vom Via 4 zur Leitbahn 3. Der Pfeil 7 zeigt dabei die Stromflussrichtung an. Dieser Stromfluss (Pfeil 7) führt zu einer Degeneration der unteren Leitbahn 2 (bei upstream die obere Bahn), was bis zum Abbruch des Kontaktes zwischen Via 4 und Leitbahn 2 führen kann. Die Ausfallzeit hängt dabei strukturbezogen vom Überlapp der Kontaktfläche des Kontaktes mit der Leitbahn im Bereich der kritischen Kante 6 ab, wobei der minimale Überlapp über technologiedefinierte Designregeln definiert wird.

Unter Produktbedingungen wird eine maximale Belegungsdichte der Metallisierung angestrebt indem die notwendige Verdrahtung im Schaltungslayout so dicht als möglich gesetzt werden, um eine Minimierung der Chipfläche zu erreichen, wobei in diesem Fall der Überlapp von Leitbahn 2 zum Via 4 minimal gezeichnet wird.

Je geringer der Überlapp ausgeprägt ist, umso geringer ist die elektrische Belastbarkeit des Kontaktes. Größere Überlapps führen zu einer längeren Lebensdauer. Für eine Technologiequalifikation muss daher der minimale Überlapp abgetestet werden, da diese Ergebnisse exemplarisch für alle möglichen Überlapps verwendet werden können. Nur diese so gewonnenen Ergebnisse gehen in die Designregeln ein. Eine Fallunterscheidung in Abhängigkeit des realisierten Überlapps wird im Produktdesign nicht vorgenommen. Aus diesem Grund sind Angaben in den Designregeln immer der "worst case"-Fall.

Für Testzwecke sollte für den Übergang von Leitbahn 2 zum Via 4 ein minimaler Überlapp realisiert werden. Im Normalfall weitet sich die Leitbahn 2 prozessbedingt erheblich auf (Fig. 2). Zum Vergleich sind hier die Layoutmaße gestrichelt gezeichnet inklusive des minimalen Überlapp von ca. 50 µm. An der kritischen Kante 6 ist der Überlapp um ein Vielfaches aufgeweitet, was zu einer viel zu optimistischen Technologiequalifikation führen würde. Diese Aufweitung ist eine prozessbedingte Folge bei der Belichtung des Resists und der anschließenden Strukturierung der Leitbahnen 2, 3 (Ätzung) in einer nicht "nested-Umgebung".

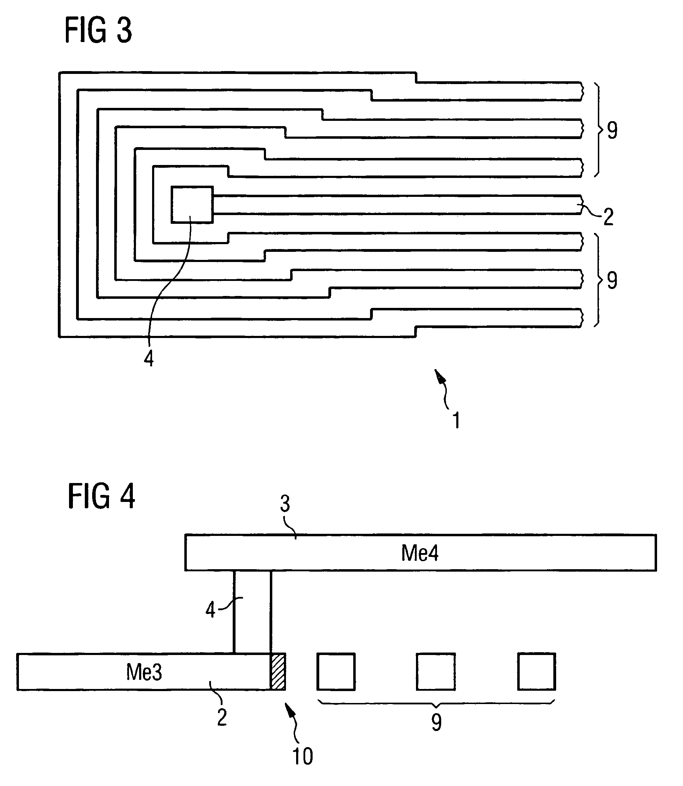

Entsprechend der Erfindung kann dies mit der Realisierung von Teststrukturen 1 durch die Realisierung einer sogenannten "nested" Umgebung mit Hilfe von Dummy-Leitbahnen 9 um die Leitbahn 2 sowie des Vias 4 (kritische Struktur) sicher verhindert werden (Fig. 3). Die aus Metall, z.B. Al, Cu, bestehenden Dummy-Leitbahnen 9 erfüllen für das hier beschriebene Beispiel einer Teststruktur keinen elektrischen Zweck, sondern "simulieren" nur eine maximale Belegungsdichte um die kritische Struktur. Diese maximale Belegungsdichte entspricht dann den realen Bedingungen im Produkt, wie auch dem kritischen Fall des minimalen Überlapps ("worst-case"). Es versteht sich, dass aus elektrisch aktiven Bahnen benachbarter Strukturen für die Teststruktur als Dummys genutzt werden können.

Fig. 4 zeigt einen schematischen Querschnitt durch eine erfindungsgemäße Teststruktur 1, bei der in der Metallisierungsebene 3 (Me3) eine "nested" Struktur mit Dummy-Leitbahnen 9 dargestellt ist. Bei einer Auswertung von Schnittbildern unter einem Elektronenstrahlenmikroskop hat sich gezeigt, dass in dieser Ebene ein größerer Überlapp als im Schaltungsdesign vorgesehen (Aufweitung 8) unterdrückt worden ist. Das realisierte Minimum an Überdeckung 10 ist aus der schematischen Darstellung nach Fig. 4 schematisch ersichtlich.

Auf entsprechende Weise kann auch in anderen Metallisierungs- bzw. Kontaktebenen vorgegangen werden.

### Bezugzeichenliste

- 1: Teststruktur
- 2: Leitbahn
- 3: Leitbahn
- 4: Via
- 5: Kontaktloch
- 6: kritische Kante
- 7: Pfeil (Stromflussrichtung)
- 8: Aufweitung
- 9: Dummy-Leitbahn
- 10: Minimum an Überdeckung 10
- Me3: Metallisierungsebene 3
- Me4: Metallisierungsebene 4

## Patentansprüche

1. Teststruktur zur Bestimmung der elektrischen Belastbarkeit von elektrischen Verbindungen zwischen übereinander angeordneten Leitbahnen durch in Kontaktlöchern angeordnete Vias auf einem Testchip, **dadurch gekennzeichnet, dass** um jedes Via (4) bzw. Kontaktloch (5) und die zugehörige Leitbahn (2; 3) herum, zumindest in der Metallisierungsebene der obersten und/oder der darunter liegenden Leitbahnebene (Me3; Me4) mehrere Dummy-Leitbahnen (9) mit maximaler Belegungsdichte angeordnet sind, indem die Verdrahtung im Schaltungslayout so dicht als möglich gesetzt wird.

2. Teststruktur nach Anspruch 1, **dadurch gekennzeichnet, dass** die Dummy-Leitbahnen (9) das Via (4) bzw. Kontaktloch (5) und die zugehörige Leitbahn (2; 3) im Wesentlichen äquidistant umgeben.

3. Teststruktur nach Anspruch 1, **dadurch gekennzeichnet, dass** die Leitbahnen (2, 3) und die Dummy-Leitbahnen (9) aus Metall bestehen.

4. Teststruktur nach Anspruch 1, **dadurch gekennzeichnet, dass** die Leitbahnen (2, 3) und die Dummy-Leitbahnen (9) aus Aluminium bestehen.

5. Teststruktur nach Anspruch 1, **dadurch gekennzeichnet, dass** die Leitbahnen (2, 3) und die Dummy-Leitbahnen (9) aus Polysilizium bestehen.

## Claims

1. Test structure for determining the electrical loadability of electrical connections between interconnects which are arranged one above the other by means of vias arranged in contact holes on a test chip, **characterized in that** a plurality of dummy interconnects (9) are arranged, with maximum coverage density, around each via (4) or contact hole (5), respectively, and the associated interconnect (2; 3) at least in the metallization plane (Me3; Me4) of the uppermost interconnect plane and/or the interconnect plane lying beneath the latter by placing the wiring as densely as possible in the circuit layout.

2. Test structure according to Claim 1, **characterized in that** the dummy interconnects (9) essentially surround the via (4) or contact hole (5), respectively, and the associated interconnect (2; 3) in an equidistant manner.

3. Test structure according to Claim 1, **characterized in that** the interconnects (2, 3) and the dummy interconnects (9) are composed of metal.

4. Test structure according to Claim 1, **characterized in that** the interconnects (2, 3) and the dummy interconnects (9) are composed of aluminium.

5. Test structure according to Claim 1, **characterized in that** the interconnects (2, 3) and the dummy interconnects (9) are composed of polysilicon.

## Revendications

1. Structure de test destinée à déterminer la capacité de charge électrique de liaisons électriques entre des pistes conductrices disposées les unes au-dessus des autres au moyen de traversées disposées dans des trous de contacts sur une puce de test, **caractérisée en ce que** plusieurs pistes conductrices factices (9) sont disposées avec une densité d'implantation maximale autour de chaque traversée (4) ou trou de contact (5) et la piste conductrice (2 ; 3) correspondante, au moins dans le plan de métallisation (Me3 ; Me4) du plan de la piste conductrice qui se trouve au-dessus et/ou au-dessous **en ce que** le câblage dans l'implantation du circuit est réalisé le plus densément possible.

2. Structure de test selon la revendication 1, **caractérisée en ce que** les pistes conductrices factices (9) entourent la traversée (4) ou le trou de contact (5) ainsi que la piste conductrice (2 ; 3) correspondante de manière essentiellement équidistante.

3. Structure de test selon la revendication 1, **caractérisée en ce que** les pistes conductrices (2, 3) et les pistes conductrices factices (9) sont en métal.

4. Structure de test selon la revendication 1, **caractérisée en ce que** les pistes conductrices (2, 3) et les pistes conductrices factices (9) sont en aluminium.

5. Structure de test selon la revendication 1, **caractérisée en ce que** les pistes conductrices (2, 3) et les pistes conductrices factices (9) sont en polysilicium.
